# EUROPEAN PATENT APPLICATION

(11) **EP 4 819 269 A1**
(43) Date of publication of application: **07.10.2026**
(21) Application number: 26157931.2
(22) Date of filing: 11.02.2026
(51) Int. Cl.: H01M 10/04, H01M 10/42, H01M 10/48, H01M 50/209, H01M 50/211, H01M 50/242, H01M 50/249

(54) **SECONDARY BATTERY MODULE**

(30) Priority: 31.03.2025 KR 20250041650
(71) Applicant: SAMSUNG SDI CO., LTD., Yongin-si, Gyeonggi-do 17084 (KR)
(72) Inventor: PARK, Junhwa, 17084 Yongin-si (KR); KIM, Beomjoo, 17084 Yongin-si (KR); PARK, Kyunghoon, 17084 Yongin-si (KR)
(74) Representative: Marks & Clerk LLP

(57) **Abstract**

A secondary battery module includes: a cell stack including a plurality of battery cells linearly arranged with respect to each other; a module main body including a variable housing accommodating the battery cells, the variable housing having an adjustable length in an arrangement direction of the battery cells, the variable housing supporting the battery cells such that the battery cells are in close contact with each other; a pressure sensor configured to detect a change in pressure of the battery cells applied to the variable housing; a controller configured to output a control signal based on the pressure information received from the pressure sensor; and a housing length adjuster operated by the controller to adjust the length of the variable housing.

## Description

### BACKGROUND

### 1. Field

Aspects of embodiments of the present disclosure relate to a secondary battery module.

### 2. Description of the Related Art

Secondary batteries are batteries that are designed to be charged and discharged, different from primary batteries, which are not designed to be recharged. A secondary battery generally includes an electrode assembly formed of electrode plates including positive and negative electrodes, a case that accommodates the electrode assembly, an electrode terminal connected to the electrode assembly, a vent for degassing gas generated inside the case, etc.

A secondary battery module generally includes a plurality of battery cells (e.g., a plurality of secondary batteries) and a housing that accommodates the battery cells. However, because a conventional secondary battery module has a housing with a fixed internal volume, if (or when) a battery cell expands due to swelling, the battery cell may be damaged by a reaction force from an inner wall surface of the housing. Due to the reaction force, an external casing or frame of the battery cell may be broken or cracks can occur in a coating layer inside the battery cell. Such physical damage can result in a degradation of performance or a shortened life of the battery cell.

There is a need for a secondary battery module that can maintain a balance of pressure between battery cells so that an operation thereof can be performed stably.

The above information disclosed in this Background section is for enhancement of understanding of the background of the present disclosure, and therefore, it may contain information that does not constitute the related (or prior) art.

### SUMMARY

Embodiments of the present disclosure provide a secondary battery module that does not apply a pressure burden onto battery cells due to swelling that occurs during charging and discharging and maintains an appropriate pressure balance between the battery cells.

According to an embodiment of the present disclosure, a secondary battery module including a cell stack including a plurality of battery cells linearly arranged with respect to each other, a module main body including a variable housing accommodating the battery cells and configured to have an adjustable length in an arrangement direction of the battery cells and accommodating the battery cells such that the battery cells are in close contact with each other, a pressure sensor configured to detect a change in pressure of the battery cells applied to the variable housing, a controller configured to output a control signal based on detected information received from the pressure sensor, and a housing length adjuster operated by the controller to adjust the length of the variable housing.

The variable housing may comprise a fixed housing accommodating the battery cells; and a movable housing partially accommodating the fixed housing and configured to be movable relative to the fixed housing.

One end portion of the fixed housing may be closed and another end portion toward the movable housing may be open, and the movable housing may correspond to the other end portion of the fixed housing.

Two end portions of the fixed housing may be open, and the movable housing corresponds to each of the two end portions of the fixed housing.

The secondary battery module may further comprise a pressing block in the variable housing, facing an end portion of the cell stack, and configured to apply a reaction force to the cell stack when the cell stack expands.

The housing length adjuster may comprise a plurality of housing length adjusters symmetrically installed outside the variable housing.

According to another embodiment of the present disclosure, a secondary battery module includes a cell stack including a plurality of battery cells linearly arranged with respect to each other, a module main body including a variable housing accommodating the battery cells, the variable housing having an adjustable length in an arrangement direction of the battery cells and accommodating the battery cells such that the battery cells are in close contact with each other, a state of charge (SOC) detector configured to detect an SOC during charging and discharging of the battery cells, a controller configured to identify predicted expansion and contraction lengths of the cell stack according to an amount of charging and discharging of the battery cells based on the SOC and output a control signal, and a housing length adjuster configured to adjust the length of the variable housing based on the control signal.

The module main body may further comprise a displacement detector configured to detect a change in length of the variable housing due to an operation of the housing length adjuster and to transmit the detected change to the controller.

The variable housing may comprise: a fixed housing accommodating the battery cells; and a movable housing partially accommodating the fixed housing and configured to be movable relative to the fixed housing.

One end portion of the fixed housing may be closed and another end portion toward the movable housing may be open, and the movable housing corresponds to the other end portion of the fixed housing.

Two end portions of the fixed housing may be open, and the movable housing may correspond to each of the two end portions of the fixed housing.

According to another embodiment of the present disclosure, a secondary battery module includes a cell stack including a plurality of battery cells linearly arranged with respect to each other, a module main body including a variable housing accommodating the battery cells, the variable housing having an adjustable length in an arrangement direction of the battery cells and accommodating the battery cells such that the battery cells are in close contact with each other, a displacement sensing unit configured to detect a change in length of the cell stack due to charging or discharging of the battery cells, a controller configured to receive information about the change in length of the cell stack from the displacement sensing unit and to output a control signal based on the information about the change in length, and a housing length adjuster configured to receive the control signal and to adjust the length of the variable housing based on the control signal.

Aspects and features of the present disclosure are not limited to those described above, and other aspects and features not specifically mentioned herein will be clearly understood by those skilled in the art from the description of embodiments of the present disclosure, provided below.

The variable housing may comprise: a fixed housing accommodating the battery cells; and a movable housing partially accommodating the fixed housing and configured to be movable relative to the fixed housing.

One end portion of the fixed housing may be closed and another end portion toward the movable housing may be open, and the movable housing may correspond to the other end portion of the fixed housing.

Two end portions of the fixed housing may be open, and the movable housing may correspond to each of the two end portions of the fixed housing.

At least some of the above and other features of the invention are set out in the claims.

### BRIEF DESCRIPTION OF THE DRAWINGS

The above and other aspects and features of the present disclosure will become more apparent to those of ordinary skill in the art by describing, in detail, embodiments thereof with reference to the accompanying drawings, in which:
FIG. 1 is a perspective view of a pouch type battery cell that may be accommodated in a secondary battery module according to an embodiment of the present disclosure;
FIG. 2 is a view of an internal structure of the battery cell shown in FIG. 1;
FIG. 3 is a perspective view of a prismatic battery cell that may be accommodated in a secondary battery module according to an embodiment of the present disclosure;
FIG. 4 is a cross-sectional view of the battery cell shown in FIG. 3;
FIG. 5 is a block diagram describing an overall configuration of a secondary battery module according to some embodiments of the present disclosure;
FIG. 6 is a partial cross-sectional view of a module main body of the secondary battery module according to an embodiment of the present disclosure;
FIG. 7 is an exploded view of a fixed housing and a movable housing shown in FIG. 6;
FIG. 8 is a perspective view of the fixed housing and the movable housing shown in FIG. 7 in a coupled state;
FIG. 9 is a partial cross-sectional plan of the module main body of the secondary battery module according to another embodiment of the present disclosure;
FIG. 10 is an exploded view of the fixed housing and the movable housing shown in FIG. 9;
FIG. 11 is a perspective view of the fixed housing and the movable housing shown in FIG. 10 in a coupled state;
FIG. 12 is a block diagram describing an overall configuration of a secondary battery module according to another embodiment of the present disclosure;
FIG. 13 is a side view of a module main body of the secondary battery module according to another embodiment of the present disclosure;
FIG. 14 is a partial cross-sectional view of the module body shown in FIG. 13;
FIG. 15 is a side view of the module body of the secondary battery module according to another embodiment of the present disclosure;
FIG. 16 is a partial cross-sectional view of the secondary battery module shown in FIG. 15;
FIG. 17 is a block diagram describing an overall configuration of a secondary battery module according to another embodiment of the present disclosure;
FIG. 18 is a view showing an internal structure of a module main body of the secondary battery module according to another embodiment of the present disclosure;
FIG. 19 is a view describing a structure of an internal displacement sensor shown in FIG. 18;
FIG. 20 is a view of the module body of the secondary battery module according to another embodiment of the present disclosure;
FIG. 21 is a perspective view of a secondary battery pack to which the secondary battery module according to an embodiment of the present disclosure is applied; and
FIG. 22 is a view of the secondary battery pack shown in FIG. 21 mounted on a vehicle.

### DETAILED DESCRIPTION

Hereinafter, embodiments of the present disclosure will be described, in detail, with reference to the accompanying drawings. The terms or words used in the specification and claims should not be narrowly interpreted according to their general or dictionary meanings but should be interpreted as having meanings and concepts that are consistent with the technical idea of the present disclosure on the basis of the principle that an inventor can be his/her own lexicographer to appropriately define concepts of terms to describe his/her invention in the best way. The embodiments described in this specification and the configurations shown in the drawings are only some embodiments of the present disclosure and do not represent all of the technical ideas of the present disclosure. Accordingly, it should be understood that there may be various equivalents and modifications that can replace them at the time of filing this application.

Further, when used herein, the terms "comprise" or "comprising" and/or "include" or "including" specify the presence of stated features, numbers, steps, operations, members, elements, and/or groups thereof, but do not preclude the presence or addition of one or more other features, numbers, operations, members, elements, and/or groups thereof.

In addition, the accompanying drawings may not be illustrated to scale and the dimensions of some components may be exaggerated. In addition, the same reference numbers may denote the same components in different embodiments.

References to two compared elements, features, etc. as being "the same" may mean that they are "substantially the same." Accordingly, "substantially the same" may include a deviation that is considered low in the art, for example, a deviation within about 5%. In addition, uniformity of a parameter over a given region may mean uniformity from the viewpoint of an average.

Although "first," "second," etc. are used to describe various components, these components are not limited by these terms. These terms are used only to distinguish one component from another, and unless otherwise stated, it is obvious that a first component may be a second component.

Throughout the specification, unless otherwise stated, each element may be singular or plural.

Arranging an arbitrary element "above (or below)" or "on (under)" another element may mean that the arbitrary element may contact the upper (or lower) surface of the element, and another element may also be interposed between the element and the arbitrary element located on (or under) the element.

Also, when a component is described as being "on," "connected to," or "coupled to" another component, it should be understood that the components may be directly connected or coupled to one another, but that other components may also be "interposed" between the components, or that each component may be "connected," "coupled," or "coupled" through the other components.

As used herein, the term "and/or" includes any and all combinations of one or more of the associated items listed. Further, the use of "may" if describing embodiments of the present disclosure relates to "one or more embodiments of the present disclosure." Expressions, such as "at least one of" and "any one of," before a list of elements, modify the entire list of elements and do not modify the individual elements of the list.

Throughout the specification, if "A and/or B" is stated, it means A, B or A and B, unless otherwise stated, and when "C to D" is stated, it means C or more and D or less, unless otherwise specified.

When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations.

The terms "use" may be considered synonymous with the terms "utilize." As used herein, the terms "substantially," "about," and similar terms are used as terms of approximation and not as terms of degree and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientations depicted in the drawings. For example, if the device in the figures is turned over, elements described as "below" or "beneath" other elements or features would then be oriented "above" or "over" the other elements or features. Thus, the term "below" may encompass both an orientation of above and below.

A person of ordinary skill in the art would appreciate, in view of the present disclosure in its entirety, that each suitable feature of the various embodiments of the present disclosure may be combined or combined with each other, partially or entirely, and may be technically interlocked and operated in various suitable ways, and each embodiment may be implemented independently of each other or in conjunction with each other in any suitable manner unless otherwise stated or implied.

The controller and/or any other relevant devices or components according to embodiments of the present disclosure described herein may be implemented utilizing any suitable hardware, firmware (e.g., an application-specific integrated circuit), software, and/or a suitable combination of software, firmware, and hardware. For example, the various components of the controller may be formed on one integrated circuit (IC) chip or on separate IC chips. Further, the various components of the controller may be implemented on a flexible printed circuit film, a tape carrier package (TCP), a printed circuit board (PCB), or formed on a same substrate as the controller. Further, the various components of the controller may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device or the functionality of a particular computing device may be distributed across one or more other computing devices without departing from the scope of the example embodiments of the present disclosure.

The terminology used herein is for the purpose of describing embodiments of the present disclosure and is not intended to be limiting of the present disclosure.

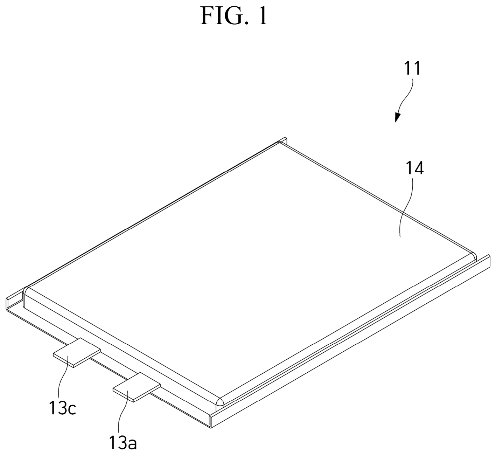

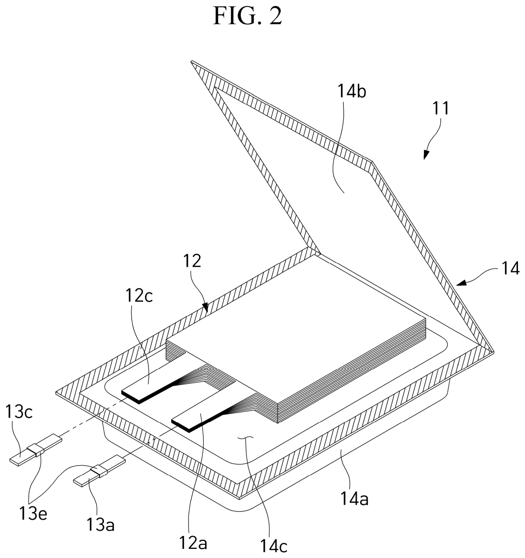

FIG. 1 is a perspective view of a pouch type battery cell 11 that may be accommodated in a secondary battery module according to embodiments of the present disclosure, and FIG. 2 is a view of an internal structure of the battery cell 11 shown in FIG. 1.

As shown, the pouch type battery cell 11 may include a pouch 14 and an electrode assembly 12.

The pouch 14 is a container (or case) formed of a flexible synthetic resin film and may include a main body 14a and a cover 14b. The main body 14a provides (or forms) an internal space 14c that may accommodate the electrode assembly 12. The internal space 14c is covered by the cover 14b. The main body 14a and the cover 14b may be fusion-bonded in a mutually bonded state. FIG. 1 shows a state in which outer edges of the main body 14a and the cover 14b are fusion-bonded to each other.

The electrode assembly 12 is accommodated in an internal space provided by the pouch 14. The electrode assembly 12 may include a positive electrode plate, a negative electrode plate, and a separator. The electrode assembly 12 may be a wound type or a stacked type. A first electrode tab 12a and a second electrode tab 12c of the electrode assembly 12 may be electrically connected to a first terminal lead 13a and a second terminal lead 13c outside the electrode assembly 12, respectively. A tab film 13e for insulation from the pouch 14 may be attached to the first terminal lead 13a and the second terminal lead 13c. The first terminal lead 13a and the second terminal lead 13c may be connected to a circuit board or an electrical part of a battery-operated product (e.g., an electrical or electronic device, such as a mobile phone, a tablet, an electric fan, etc.).

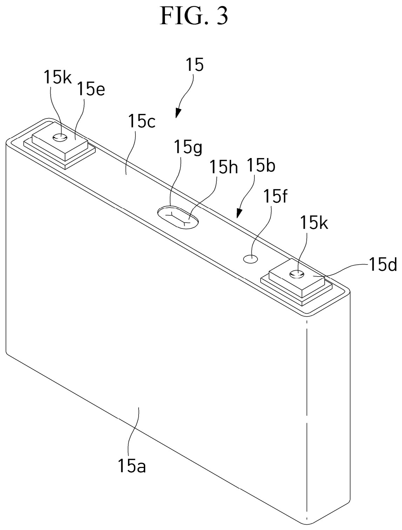

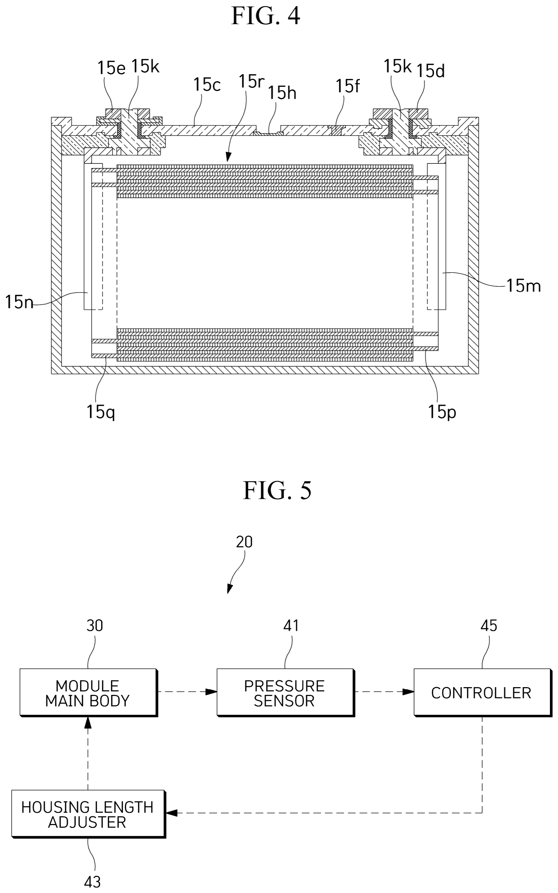

FIG. 3 is a perspective view of a prismatic battery cell 15 that may be accommodated in a secondary battery module according to embodiments of the present disclosure. FIG. 4 is a cross-sectional view of the battery cell 15 shown in FIG. 3.

A case 15a forms the overall appearance of the prismatic battery 15 and may be formed of a conductive metal, such as aluminum, an aluminum alloy, nickel-plated steel, plastics, composite materials, etc. In addition, the case 15a may provide a space for accommodating an electrode assembly therein.

A cap assembly 15b may include a cap plate 15c that covers an opening in the case 15a. In some embodiments, the case 15a and the cap plate 15c may be made of a conductive material. A positive electrode terminal 15d and a negative electrode terminal 15e may be electrically connected to respective positive and negative electrodes inside the case 15a and may be installed to protrude outwardly through the cap plate 15c.

An electrolyte injection port 15f and a vent hole 15g may be formed in the cap plate 15c, and a vent part 15h may be joined to (e.g., coupled to or may seal) the vent hole 15g. The vent part 15h is configured to be opened (e.g., to burst or tear) by excess gas generated inside the battery to perform a degassing function.

The electrode assembly 15r can be formed by winding or stacking a first electrode plate, a separator, and a second electrode plate formed in a plate or a film shape. When the electrode assembly 15r is a wound stack, a winding axis may be parallel to the longitudinal direction of the case 15a. In other embodiments, the electrode assembly 15r may be a stack type rather than a winding type, but the shape of the electrode assembly 15r is not limited in the present disclosure.

In addition, the electrode assembly 15r may be a Z-stack electrode assembly in which a positive electrode plate and a negative electrode plate are inserted into both sides of (e.g., opposite sides of) a separator, which is then bent (or folded) into a Z-stack. In addition, one or more electrode assemblies 15r may be stacked such that long sides of the electrode assemblies are adjacent to each other and accommodated together in the case 15a, and the number of electrode assemblies in the case 15a is not limited in the present disclosure. The first electrode plate of the electrode assembly 15r may act as a negative electrode, and the second electrode plate may act as a positive electrode. Of course, the reverse is also possible.

The first electrode plate may be formed by applying a first electrode active material, such as graphite, carbon, or the like, to a first electrode current collector formed of a metal foil, such as copper, a copper alloy, nickel, a nickel alloy, or the like. The first electrode plate may include a first electrode tab (e.g., a first uncoated portion) 15p that is a region to which the first electrode active material is not applied. The first electrode tab 15p may act as a current flow path between the first electrode plate and a first current collector 15m. In some embodiments, when the first electrode plate is manufactured, the first electrode tab 15p is formed by being cut in advance to protrude to one side of the electrode assembly, or the first electrode tab protrudes to one side of the electrode assembly more than (e.g., farther than or beyond) the separator without being separately cut.

The second electrode plate may be formed by applying a second electrode active material, such as a transition metal oxide, on a second electrode current collector formed of a metal foil, such as aluminum or an aluminum alloy. The second electrode plate may include a second electrode tab (e.g., a second uncoated portion) 15q that is a region to which the second electrode active material is not applied. The second electrode tab 15q may act as a current flow path between the second electrode plate and a second current collector 15n. In some embodiments, the second electrode tab 15q may be formed by being cut in advance to protrude to the other side (e.g., the opposite side) of the electrode assembly when the second electrode plate is manufactured, or the second electrode plate may protrude to the other side of the electrode assembly more than (e.g., farther than or beyond) the separator without being separately cut.

Referring to FIG. 4, the first electrode tab 15p and the second electrode tab 15q are illustrated as being positioned on the right side and the left side of the electrode assembly 15r, respectively; however, in some embodiments, the first electrode tab 15p and the second electrode tab 15q may both be positioned on the right side or the left side of the electrode assembly 15r.

As used herein, a left surface of the electrode assembly 15r refers to a surface of a vertical surface of the electrode assembly 15r to which the second current collector 15n is bonded, and a right surface thereof refers to an opposite surface to which the first current collector 15m is bonded. The terms left side and right side of the electrode assembly 15r used above may change when the battery rotates left and right or up and down.

The separator prevents or substantially reduces instances of a short circuit between the first electrode and the second electrode while allowing movement of lithium ions therebetween. The separator may be made of, for example, a polyethylene film, a polypropylene film, a polyethylene-polypropylene film, or the like.

In some embodiments, an electrode assembly 15r is accommodated in the case 15a along with an electrolyte.

In the electrode assembly 15r, the first current collector 15m and the second current collector 15n may be welded and connected to the first electrode tab 15p extending from the first electrode plate and the second electrode tab 15q extending from the second electrode plate, respectively.

The first current collector 15m and the second current collector 15n are connected to the positive electrode terminal 15d and the negative electrode terminal 15e through connection members 15k, respectively. In some embodiments, the connection members 15k may each have a threaded outer peripheral surface and may be fastened to the positive electrode terminal 15d and the negative electrode terminal 15e by screwing. However, the present disclosure is not limited thereto. For example, the connection members 15k may also be coupled to the positive electrode terminal 15d and the negative electrode terminal 15e by riveting or welding.

A description of materials that can be used for the electrode plate of the above electrode assembly is briefly provided below.

As the positive electrode active material, a compound capable of reversibly intercalating/deintercalating lithium (e.g., a lithiated intercalation compound) may be used. For example, at least one of a composite oxide of lithium and a metal selected from cobalt, manganese, nickel, and combinations thereof may be used.

The composite oxide may be a lithium transition metal composite oxide, and examples thereof may include a lithium nickel-based oxide, a lithium cobalt-based oxide, a lithium manganese-based oxide, a lithium iron phosphate-based compound, a cobalt-free nickel-manganese-based oxide, or a combination thereof.

As an example, a compound represented by any one of the following formulas may be used: LiₐA_{1-b}X_{b}O_{2-c}D_{c} (0.90≤a≤1.8, 0≤b≤0.5, 0≤c≤0.05); LiₐMn_{2-b}X_{b}O_{4-c}D_{c} (0.90≤a≤1.8, 0≤b≤0.5, 0≤c≤0.05); LiₐNi_{1-b-c}Co_{b}X_{c}O_{2-α}D_{α} (0.90≤a≤1.8, 0≤b≤0.5, 0≤c≤0.5, 0<α<2); LiₐNi_{1-b-c}Mn_{b}X_{c}O_{2-α}D_{α} (0.90≤a≤1.8, 0≤b≤0.5, 0≤c≤0.5, 0<α<2); LiₐNi_{b}Co_{c}L¹_{d}GₑO₂ (0.90≤a≤1.8, 0≤b≤0.9, 0≤c≤0.5, 0≤d≤0.5, 0≤e≤0.1); LiₐNiG_{b}O₂ (0.90≤a≤1.8, 0.001≤b≤0.1); LiₐCoG_{b}O₂ (0.90≤a≤1.8, 0.001≤b≤0.1); LiₐMn_{1-b}G_{b}O₂ (0.90≤a≤1.8, 0.001≤b≤0.1); LiₐMn₂G_{b}O₄ (0.90≤a≤1.8, 0.001≤b≤0.1); LiₐMn_{1-g}G_{g}PO₄ (0.90≤a≤1.8, 0≤g≤0.5); Li_{(3-f)}Fe₂(PO₄)₃ (0≤f≤2); LiₐFePO₄ (0.90≤a≤1.8).

In the above formulas: A is Ni, Co, Mn, or a combination thereof; X is Al, Ni, Co, Mn, Cr, Fe, Mg, Sr, V, a rare earth element, or a combination thereof; D is O, F, S, P, or a combination thereof; G is Al, Cr, Mn, Fe, Mg, La, Ce, Sr, V, or a combination thereof; and L' is Mn, Al, or a combination thereof.

A positive electrode for a lithium secondary battery may include a substrate and a positive electrode active material layer formed on the substrate. The positive electrode active material layer may include a positive electrode active material and may further include a binder and/or a conductive material.

The content of the positive electrode active material is in a range of about 90 wt% to about 99 wt% on the basis of 100 wt% of the positive electrode active material layer, and the content of the binder and the conductive material is in a range of about 0.5 wt% to about 5 wt%, respectively, on the basis of 100 wt% of the positive electrode active material layer.

The substrate may be aluminum (Al) but is not limited thereto.

The negative electrode active material may include a material capable of reversibly intercalating/deintercalating lithium ions, lithium metal, an alloy of lithium metal, a material capable of being doped and undoped with lithium, or a transition metal oxide.

The material capable of reversibly intercalating/deintercalating lithium ions may be a carbon-based negative electrode active material, which may include, for example, crystalline carbon, amorphous carbon, or a combination thereof. Examples of the crystalline carbon may include graphite, such as natural graphite or artificial graphite, and examples of the amorphous carbon may include soft carbon, hard carbon, a pitch carbide, a meso-phase pitch carbide, sintered coke, and the like.

A Si-based negative electrode active material or a Sn-based negative electrode active material may be used as the material capable of being doped and undoped with lithium. The Si-based negative electrode active material may be silicon, a silicon-carbon composite, SiOₓ (0<x≤2), a Si-based alloy, or a combination thereof.

The silicon-carbon composite may be a composite of silicon and amorphous carbon. According to one embodiment, the silicon-carbon composite may be in the form of a silicon particle and amorphous carbon coated on the surface of the silicon particle.

The silicon-carbon composite may further include crystalline carbon. For example, the silicon-carbon composite may include a core including crystalline carbon and silicon particles and an amorphous carbon coating layer located on a surface of the core.

A negative electrode for a lithium secondary battery may include a substrate and a negative electrode active material layer disposed on the substrate. The negative electrode active material layer may include a negative electrode active material and may further include a binder and/or a conductive material.

For example, the negative electrode active material layer may include about 90 wt % to about 99.5 wt % of a negative electrode active material, about 0.5 wt % to about 5 wt % of a binder, and about 0 wt % to about 5 wt % of a conductive material.

A non-aqueous binder, an aqueous binder, a dry binder, or a combination thereof may be used as the binder. When an aqueous binder is used as the negative electrode binder, a cellulose-based compound capable of imparting viscosity may be further included.

As the negative electrode substrate, one selected from copper foil, nickel foil, stainless steel foil, titanium foil, nickel foam, copper foam, conductive metal-coated polymer substrate, and combinations thereof may be used.

An electrolyte for a lithium secondary battery may include a non-aqueous organic solvent and a lithium salt.

The non-aqueous organic solvent acts as a medium through which ions involved in the electrochemical reaction of the battery can move.

The non-aqueous organic solvent may be a carbonate-based, an ester-based, an ether-based, a ketone-based, an alcohol-based solvent, an aprotic solvent, and may be used alone or in combination of two or more.

In addition, when a carbonate-based solvent is used, a mixture of cyclic carbonate and chain carbonate may be used.

Depending on the type of lithium secondary battery, a separator may be present between the first electrode plate (e.g., the negative electrode) and the second electrode plate (e.g., the positive electrode). As the separator, polyethylene, polypropylene, polyvinylidene fluoride, or a multilayer film including two or more layers thereof may be used.

The separator may include a porous substrate and a coating layer including an organic material, an inorganic material, or a combination thereof on one or both surfaces of the porous substrate.

The organic material may include a polyvinylidene fluoride-based polymer or a (meth)acrylic polymer.

The inorganic material may include inorganic particles selected from Al₂O₃, SiO₂, TiO₂, SnO₂, CeO₂, MgO, NiO, CaO, GaO, ZnO, ZrO₂, Y₂O₃, SrTiO₃, BaTiO₃, Mg(OH)₂, boehmite, and combinations thereof but is not limited thereto.

The organic material and the inorganic material may be mixed in one coating layer or may be in the form of a coating layer containing an organic material and a coating layer containing an inorganic material that are stacked on each other.

FIG. 5 is a block diagram describing an overall configuration of a secondary battery module 20 according to some embodiments of the present disclosure.

Referring to FIG. 5, a secondary battery module 20 according to some embodiments may include a module main body 30, a pressure sensor 41, a controller 45, and a housing length adjuster 43.

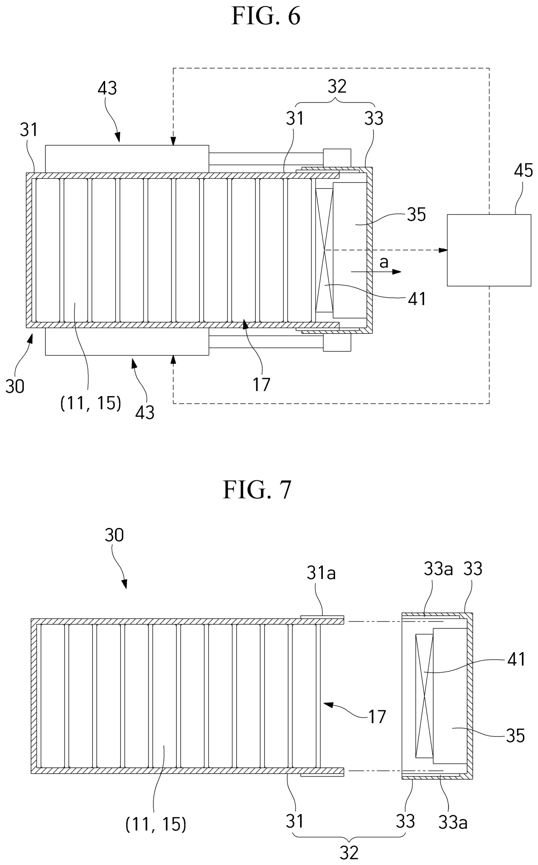

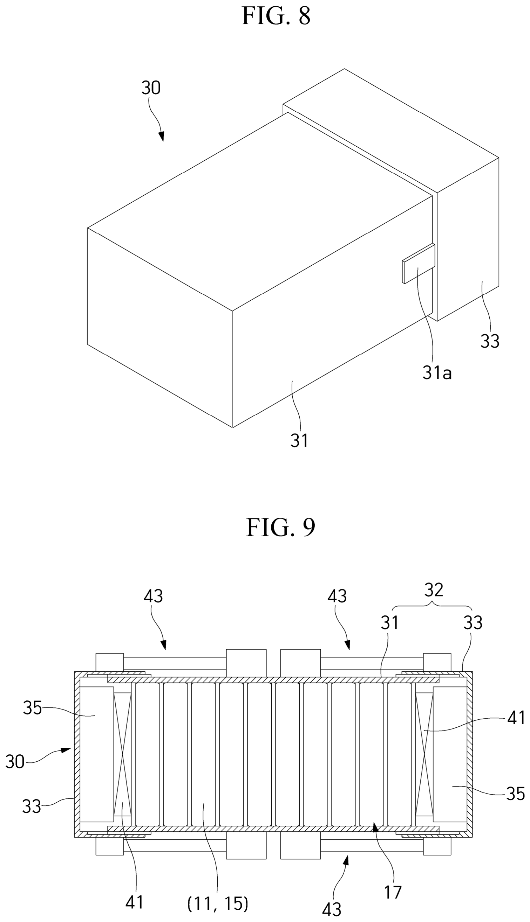

FIG. 6 is a view describing the secondary battery module 20 according to some embodiments of the present disclosure in more detail, and FIG. 7 is an exploded view of a fixed housing 31 and a movable housing 33 shown in FIG. 6. In addition, FIG. 8 is a perspective view of the fixed housing 31 and the movable housing 33 shown in FIG. 7 in a coupled state.

The module main body 30 may include a plurality of battery cells 11, 15 and a variable housing 32 as shown in FIG. 6. The battery cells 11, 15 may be linearly arranged in close contact with each other to form a cell stack 17. The battery cells 11, 15 may each be a pouch or prismatic type but are not limited thereto. An inter-cell insulation material or a cooling member may be interposed between individual battery cells (e.g., between adjacent battery cells) 11; 15 constituting the cell stack 17.

In addition, the variable housing 32 may accommodate the battery cells 11, 15, and a length of the variable housing 32 may be adjusted in an arrangement direction of the battery cells 11, 15. The variable housing 32 may support the battery cells 11, 15 such that the battery cells 11, 15 are in close contact with each other. For example, the variable housing 32 accommodates and supports the cell stack 17. The battery cells 11, 15 constituting the cell stack 17 may be accommodated in the variable housing 32 while in close contact with neighboring battery cells 11, 15.

As shown, the variable housing 32 may include the fixed housing 31 and the movable housing 33.

The fixed housing 31 may have (e.g., may accommodate) the cell stack 17 composed of the battery cells 11, 15 therein. The fixed housing 31 may have a structure in which one end portion is blocked and the other end portion is open toward (or facing) the movable housing 33. One end portion of the cell stack 17 may receive a support force from an inner wall surface of the fixed housing 31.

The movable housing 33 may be installed to correspond to (e.g., to cover) the other end portion of the fixed housing 31. The movable housing 33 may partially accommodate the end portion of the fixed housing 31. The movable housing 33 may be moved with respect to the fixed housing 31 by the housing length adjuster 43. For example, a position of the movable housing 33 may be adjusted in a direction of the arrow a in FIG. 6 or in a direction opposite thereto.

In addition, a slider 31a may be formed at both sides of the fixed housing 31. The slider 31a may be symmetrical to the fixed housing 31 in a left-right direction. In addition, a guide groove 33a corresponding to the slider 31a may be formed in the movable housing 33. The guide groove 33a may accommodate (e.g., may guide) the slider 31a. The slider 31a may slide while accommodated in the guide groove 33a. In this way, by using the slider 31a and the guide groove 33a, the movable housing 33 is not biased to one side when moving. The slider 31a and the guide groove 33a may also be applied to upper and lower portions of the variable housing 32.

The movable housing 33 may move with respect to the fixed housing 31, but the movable housing 33 is not moved by receiving (e.g., is not moved in response to) an expansion force of the cell stack 17. A length of the variable housing 32 that is set by the housing length adjuster 43 is maintained. When the housing length adjuster 43 does not operate, the length of the variable housing 32 does not change.

A pressing block 35 may be mounted inside the variable housing 32. The pressing block 35 is a member that faces the end portion of the cell stack 17 and applies a reaction force to the cell stack when the cell stack expands. The pressing block 35 may be formed of a metal or hard synthetic resin.

The pressure sensor 41 may detect a change in the pressure applied to the variable housing 32 by the battery cell(s) during charging and discharging of the battery cell(s). During charging and discharging, the cell stack 17 expands and/or slightly shrinks, and during this time, a pressing force of the cell stack 17 to the variable housing 32 may change. The pressure sensor 41 may be a load cell or a surface pressure measuring device. The pressure sensor 41 may be installed between the pressing block 35 and the cell stack 17, may detect the pressure transmitted from the cell stack, and may transmit the detected pressure to the controller 45.

As described above, the length of the variable housing 32 does not change before the housing length adjuster 43 operates (e.g., the length of the variable housing 32 is fixed until the housing length adjuster 43 operates). In addition, after the charging/discharging of the secondary battery module is completed, the length of the variable housing 32 is adjusted by the housing length adjuster 43 so that the variable housing presses the cell stack 17 with a reference pressure (hereinafter, this state-a state in which the length of the variable housing is adjusted to press the cell stack with the reference pressure-is referred to as an "initial state"). The reference pressure may be a pressure of the pressing block 35 pressing the cell stack 17. In addition, the reference pressure may be equal to the reaction force of the pressing block 35 on the cell stack 17.

For example, if the reference pressure is set as 20, when the cell stack 17 expands from the initial state, the cell stack presses the pressing block 35 with a pressure higher than the reference pressure, for example, 30. The pressure sensor 41 detects a pressure changing from 20 to 30 and transmits the detected information (e.g., the measured pressure) to the controller 45, and the controller 45 increases the length of the variable housing 32 to release the pressed (e.g., compressed or further pressurized) state of the battery cell.

In addition, when the cell stack 17 shrinks from the initial state, the pressure of the cell stack 17 pressing the pressing block 35 is decreased to, for example, 10. The pressure sensor 41 transmits the detected information to the controller 45. The controller 45 may decrease the length of the variable housing 32 so that the cell stack 17 is pressed with the reference pressure.

The controller 45 may receive the detected information of the pressure sensor 41 and may output a control signal. The control signal of the controller 45 may be transmitted to the housing length adjuster 43.

The housing length adjuster 43 may be operated by the controller to adjust the length of the variable housing. The length of the variable housing is a length of the secondary battery in a stacked direction. Two or more housing length adjusters 43 may be installed symmetrically on the outside of the variable housing 32. The movable housing 33 may be moved in the direction of arrow a in FIG. 6 or the direction opposite thereto by the housing length adjuster 43. The housing length adjuster 43 may be applied in various ways and configurations as long as it is configured to move the movable housing 33. For example, the housing length adjuster 43 may be an actuator, a lead screw, a linear drive, etc.

As described above, by detecting a change in the pressure of the cell stack 17 and controlling the length of the variable housing 32, an appropriate pressure between the battery cells 11, 15 constituting the cell stack 17 is maintained. By appropriately maintaining the pressure of the battery cell(s), the performance of the secondary battery module 20 may be improved and the lifetime thereof extended.

When an excessive pressure is applied to the battery cell(s), electrodes or electrolyte inside the battery cell can be damaged. In addition, a very low pressure (or no pressure) on the battery cell(s) can degrade the performance of the cell and reduce mechanical stability due to vibration or an impact. Accordingly, the pressure constituting the battery cell is appropriately maintained by using the pressure sensor 41 and the controller 45.

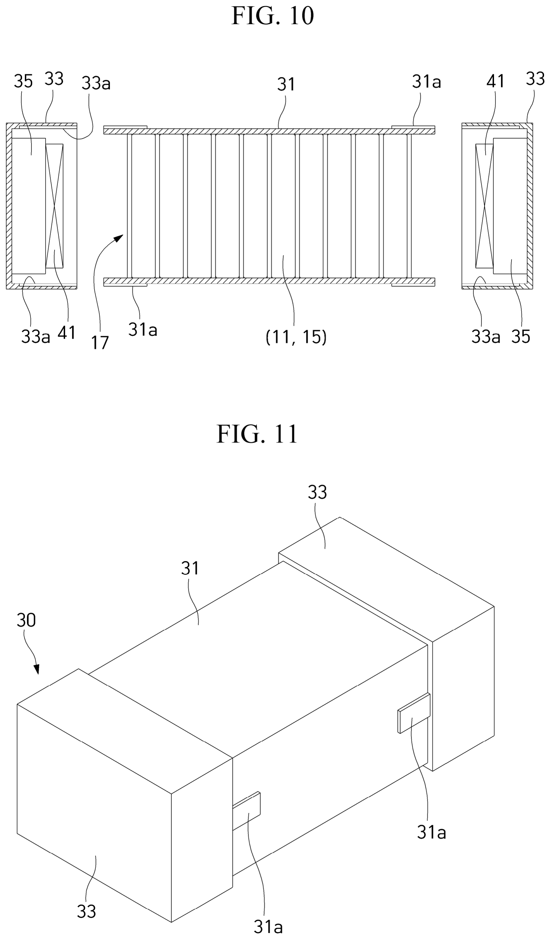

FIG. 9 is a partial cross-sectional view showing the module main body of the secondary battery module 20 according to another embodiment of the present disclosure, and FIG. 10 is an exploded view of the fixed housing 31 and the movable housing 33 shown in FIG. 9. In addition, FIG. 11 is a perspective view of the fixed housing 31 and the movable housing 33 shown in FIG. 10 in a coupled state.

Hereinafter, the same reference numerals as the above reference numerals denote the same members having the same functions, and overlapping descriptions thereof may be omitted or only briefly repeated.

As shown, the variable housing 32 may include (or may be composed of) the fixed housing 31 and two movable housings 33. The fixed housing 31 may have open both end portions (e.g., opposite open end portions) and may accommodate the cell stack 17 therein. The slider 31a may be formed symmetrically on an outer surface of the fixed housing 31.

In addition, the movable housings 33 may be installed to correspond to two end portions of the fixed housing 31. The two end portions of the movable housing 33 may be accommodated inside the fixed housing 31. In addition, the guide groove 33a may be formed in the movable housing 33. The guide groove 33a is a groove that slidably accommodates the slider 31a of the fixed housing.

In addition, the pressing block 35 and the pressure sensor 41 may be installed inside the movable housings 33 at both sides thereof. A change in pressure due to the expansion and contraction of the cell stack 17 may be detected by the pressure sensor 41. The pressure sensors 41 at both sides are connected (e.g., simultaneously connected) to the controller 45. The controller 45 may average information (e.g., pressure measurements) received from the pressure sensors 41 and may drive the housing length adjuster 43.

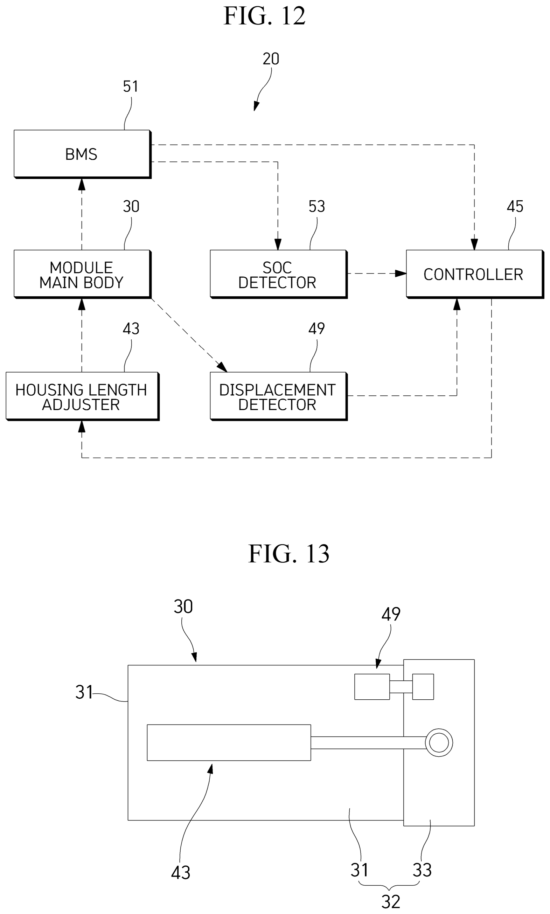

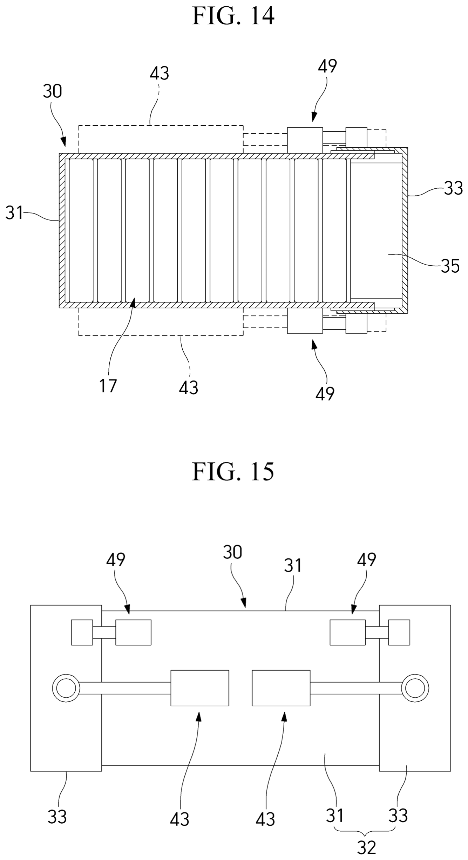

FIG. 12 is a block diagram describing an overall configuration of the secondary battery module 20 according to another embodiment of the present disclosure, and FIG. 13 is a side view of a module main body 30 of the secondary battery module 20 according to another embodiment of the present disclosure. In addition, FIG. 14 is a partial cross-sectional view of the module main body shown in FIG. 13.

As shown, the secondary battery module 20 according to another embodiment may include a module main body 30, a battery management system (BMS) 51, a state of charge (SOC) detector 53, the controller 45, the housing length adjuster 43, and a displacement detector 49.

The module main body 30 is the same as the above-described module main bodies according to various embodiments. For example, the module main body 30 includes the fixed housing 31 including (e.g., accommodating) the cell stack 17 and the movable housing 33 disposed to correspond to the fixed housing 31.

The BMS 51 may allow the cell stack 17 to operate safely and efficiently. For example, the BMS 51 monitors (e.g., continuously monitors) a voltage and current of the cell stack 17 and controls charging and discharging. In addition, the BMS 51 may be connected to the SOC detector 53 and may provide a detection source to the SOC detector 53. For example, the BMS 51 transmits information of the battery cell(s), such as a voltage, current, temperature, etc., to the SOC detector 53. The SOC detector 53 may detect the SOC based on the information received from the BMS 51. During charging and discharging of the battery cell, the SOC of the battery cell is detected (e.g., is measured and/or calculated).

By detecting the SOC of the battery cell(s), the controller 45 identifies (or determines) predicted expansion and contraction lengths of the cell stack 17 according to the amount of charging and discharging of the battery cell(s).

The controller 45 is connected to the BMS 51 and the SOC detector 53 and receives information detected by the SOC detector 53. The controller 45 may aggregate the data received from the BMS 51 and the SOC detector 53 and identify (or determine) the predicted expansion and contraction lengths of the cell stack 17. That is, based on the SOC information, the controller 45 calculates whether or not the entire length of the cell stack 17, for example, may increase by 5 mm or may decrease by 2 mm.

The controller 45 may operate the housing length adjuster 43 based on the identified information. For example, the length of the variable housing 32 is adjusted by using the housing length adjuster 43. For example, to increase the length of the cell stack 17 by about 5 mm (to maintain an appropriate pressure), the length of the variable housing 32 is increased by 5 mm, and to decrease the length of the cell stack 17 by 2 mm (to maintain an appropriate pressure), the length of the variable housing 32 is decreased by 2 mm.

The length of the variable housing 32 may be adjusted by the housing length adjuster 43. The housing length adjuster 43 may receive the control signal of the controller 45 and adjust the length of the variable housing.

The displacement detector 49 may detect a change in length of the variable housing 32 due to the operation of the housing length adjuster 43 and may transmit the detected change to the controller 45. For example, the displacement detector 49 determines whether or not the length of the variable housing 32 has actually moved by a displacement distance commanded by the controller and feeds back the result to the controller 45.

For example, the displacement detector 49 may detect a movement distance of the movable housing 33 with respect to the fixed housing 31 and may transmit a result of the detection to the controller 45. The displacement detector 49 that may perform such a role may be implemented in various ways. The displacement detector 49 may be a linear gauge or a strain sensor.

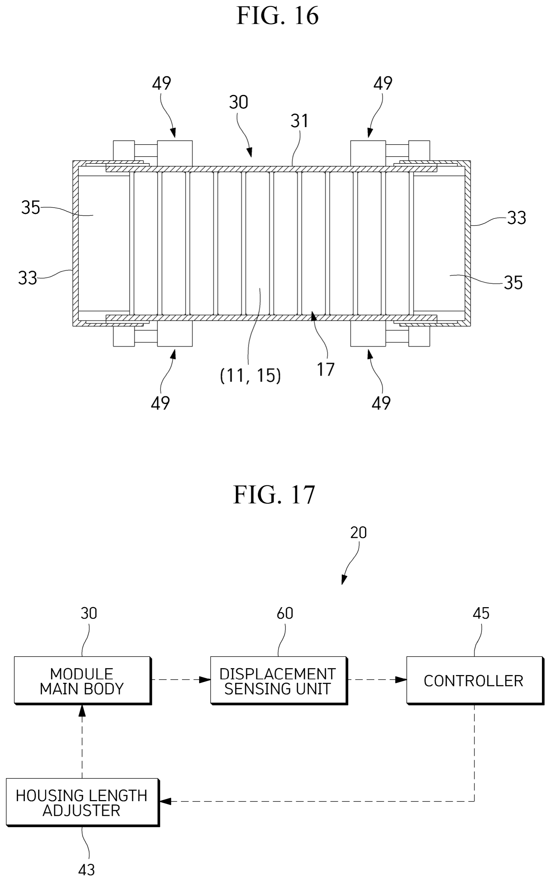

FIG. 15 is a side view of the module body of the secondary battery module 20 according to another embodiment of the present disclosure. FIG. 16 is a partial cross-sectional plan view of the secondary battery module 20 shown in FIG. 15.

As shown in FIGS. 15 and 16, two housing length adjusters 43 may be installed on both side portions (e.g., opposite side portions) of the variable housing 32 to which the movable housing 33 is applied to both sides of the fixed housing 31. Each housing length adjuster 43 may adjust the position of the movable housing 33 with respect to the fixed housing 31.

In addition, the displacement detector 49 may be installed on both side portions of the variable housing 32. A part of the displacement detector 49 is fixed on the fixed housing 31, and the other part thereof is fixed on the movable housing 33. The displacement detector 49 may detect the movement distance of the movable housing 33.

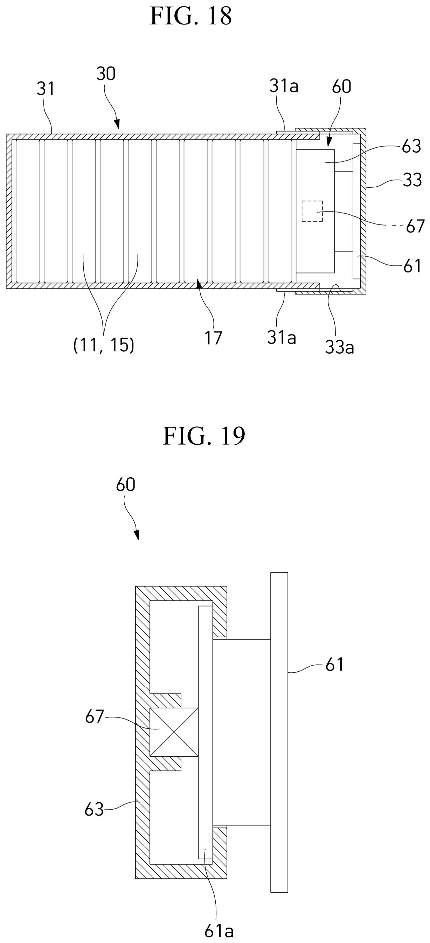

FIG. 17 is a block diagram describing an overall configuration of a secondary battery module 20 according to another embodiment of the present disclosure, and FIG. 18 is a view of an internal structure of a module main body 30 of the secondary battery module 20 according to another embodiment of the present disclosure. In addition, FIG. 19 is a view describing a structure of an internal displacement sensor shown in FIG. 18.

As shown, the secondary battery module 20 according to another embodiment may include the module main body 30, a displacement sensing unit 60, the controller 45, and the housing length adjuster 43.

The displacement sensing unit 60 may detect a change in the expansion or contraction length of the cell stack 17 due to charging and discharging of the battery cell. As shown in FIG. 18, the displacement sensing unit 60 is installed inside the variable housing 32. The displacement sensing unit 60 is positioned opposite to the cell stack 17 inside the variable housing. The displacement sensing unit 60 may detect a change in length of the cell stack 17 while in close contact with the cell stack 17.

The displacement sensing unit 60 may include a holder 61, a displacement sensor 67, and a sensor supporter 63. The holder 61 is an element fixed to the inner wall surface of the movable housing 33 and has a support plate 61a. The support plate 61a may be a rectangular plate having a thickness (e.g., a predetermined thickness) and may support the sensor supporter 63.

The displacement sensor 67 is fixed to the support plate 61a of the holder. The displacement sensor is installed between the holder 61 and the cell stack 17 to detect the change in length of the cell stack 17. The type of displacement sensor that may perform such a role may be applied in various ways. The displacement sensor 67 may be an electrical or mechanical sensor.

The sensor supporter 63 can protect the displacement sensor 67 while covering the displacement sensor 67. In addition, the sensor supporter 63 may support the displacement sensor 67 so that the displacement sensor 67 may be positioned on a central portion of the support plate 61a.

The displacement sensor 67 is connected to the controller 45. The controller 45 may receive information about the change in length of the cell stack 17 from the displacement sensing unit 60 and may drive the housing length adjuster 43 based on the received information. For example, when the length of the cell stack 17 increases by 3 mm, the controller 45 controls the housing length adjuster 43 to increase the length of the variable housing 32 by 3 mm. In addition, when the length of the cell stack 17 decreases by 1 mm, the housing length adjuster 43 decreases the length of the variable housing 32 by 1 mm. The housing length adjuster 43 receives the control signal of the controller 45 and adjusts the length of the variable housing.

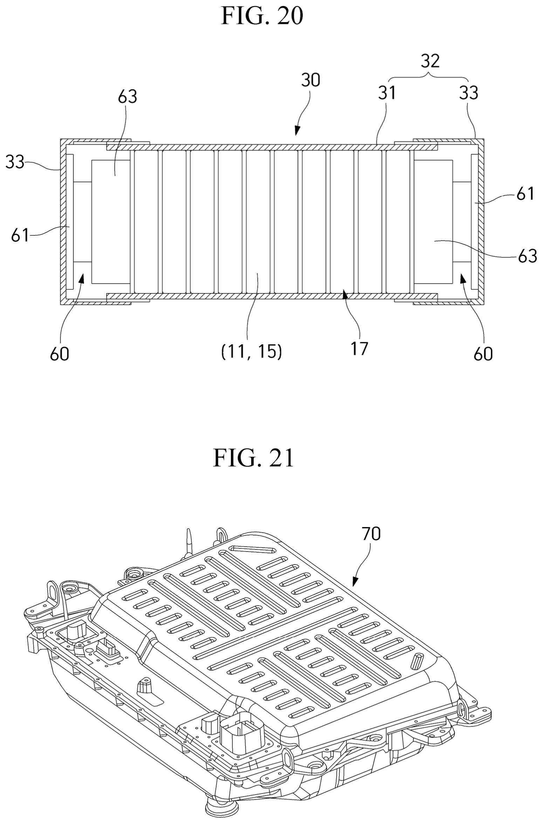

FIG. 20 is a view of the module body of the secondary battery module 20 according to another embodiment of the present disclosure.

As shown in FIG. 20, the displacement sensing units 60 are installed on both sides of (e.g., opposite sides of) the cell stack 17. The displacement sensing units 60 may be connected (e.g., simultaneously connected) to the controller 45. The controller 45 aggregates the information received from the displacement sensing units 60 on both sides and adjusts the length of the variable housing 32.

FIG. 21 is a perspective view of a secondary battery pack 70 to which the secondary battery module 20 according to an embodiment of the present disclosure is applied.

The secondary battery pack 70 may be manufacturing by accommodating a plurality of secondary battery modules 20 in a pack cell housing having a form designed to be mounted on an actual product. The pack cell housing may include fasteners and electrical outlets for product mounting. In FIG. 21, for convenience of illustration, components such as a bus bar, a cooling unit, external terminals for electrically connecting secondary batteries, etc., are not illustrated. The secondary battery pack 70 may be mounted on a vehicle. The vehicle may be, for example, an electric vehicle, a hybrid electric vehicle, or a plug-in hybrid electric vehicle. The vehicle may be a four-wheeled vehicle or a two-wheeled vehicle but is not limited thereto.

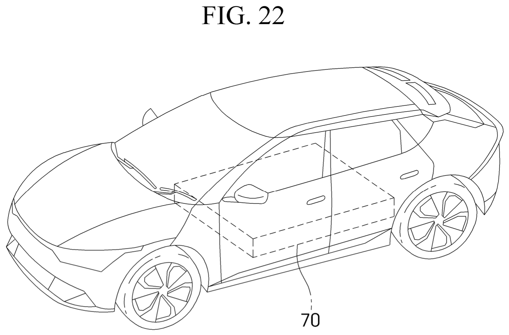

FIG. 22 is a view of the secondary battery pack 70 shown in FIG. 21 mounted on a vehicle.

FIG. 22 illustrates the secondary battery pack 70 according to an embodiment of the present disclosure mounted under a vehicle body of a vehicle. The vehicle is operated by receiving power from the secondary battery pack 70.

According to embodiments of the present disclosure, because a housing has a variable structure, there is no pressure burden on battery cells due to swelling occurring during charging and discharging, and an appropriate pressure balance between the battery cells can be maintained.

Although the present disclosure has been described above with respect to embodiments thereof, the present disclosure is not limited thereto. Various modifications and variations can be made thereto as would be understood by those skilled in the art within the scope of the present disclosure as defined by the appended claims and their equivalents.

## Claims

1. A secondary battery module comprising:
a cell stack comprising a plurality of battery cells linearly arranged with respect to each other;
a module main body comprising a variable housing configured to accommodate the battery cells, the variable housing having an adjustable length in an arrangement direction of the battery cells, the variable housing configured to support the battery cells such that the battery cells are in close contact with each other;
a pressure sensor configured to detect a change in pressure of the battery cells applied to the variable housing;
a controller configured to output a control signal based on the pressure information received from the pressure sensor; and
a housing length adjuster operatable by the controller to adjust the length of the variable housing.

2. The secondary battery module as claimed in claim 1, wherein the variable housing comprises:
a fixed housing configured to accommodate the battery cells; and
a movable housing partially accommodating the fixed housing and configured to be movable relative to the fixed housing.

3. The secondary battery module as claimed in claim 2, wherein one end portion of the fixed housing is closed and another end portion toward the movable housing is open, and
wherein the movable housing corresponds to the other end portion of the fixed housing.

4. The secondary battery module as claimed in claim 2, wherein two end portions of the fixed housing are open, and
wherein the movable housing corresponds to each of the two end portions of the fixed housing.

5. The secondary battery module as claimed in claim 1, 2, 3 or 4, further comprising a pressing block in the variable housing, facing an end portion of the cell stack, and configured to apply a reaction force to the cell stack when the cell stack expands.

6. The secondary battery module as claimed in any preceding claim, wherein the housing length adjuster comprises a plurality of housing length adjusters symmetrically installed outside the variable housing.

7. A secondary battery module comprising:
a cell stack comprising a plurality of battery cells linearly arranged with respect to each other;
a module main body comprising a variable housing configured to accommodate the battery cells, the variable housing having an adjustable length in an arrangement direction of the battery cells and configured to accommodate the battery cells such that the battery cells are in close contact with each other;
a state of charge (SOC) detector configured to detect an SOC during charging and discharging of the battery cells;
a controller configured to identify predicted expansion and contraction lengths of the cell stack according to the charging and discharging of the battery cells based on the SOC and to output a control signal; and
a housing length adjuster configured to adjust the length of the variable housing based on the control signal.

8. The secondary battery module as claimed in claim 7, wherein the module main body further comprises a displacement detector configured to detect a change in length of the variable housing due to an operation of the housing length adjuster and to transmit the detected change to the controller.

9. The secondary battery module as claimed in claim 7 or 8, wherein the variable housing comprises:
a fixed housing configured to accommodate the battery cells; and
a movable housing partially accommodating the fixed housing and configured to be movable relative to the fixed housing.

10. The secondary battery module as claimed in claim 9, wherein one end portion of the fixed housing is closed and another end portion toward the movable housing is open, and
wherein the movable housing corresponds to the other end portion of the fixed housing.

11. The secondary battery module as claimed in claim 9, wherein two end portions of the fixed housing are open, and
wherein the movable housing corresponds to each of the two end portions of the fixed housing.

12. A secondary battery module comprising:
a cell stack comprising a plurality of battery cells linearly arranged with respect to each other;
a module main body comprising a variable housing configured to accommodate the battery cells, the variable housing configured to have an adjustable length in an arrangement direction of the battery cells and configured to accommodate the battery cells such that the battery cells are in close contact with each other;
a displacement sensing unit configured to detect a change in length of the cell stack;
a controller configured to receive information about the change in length of the cell stack from the displacement sensing unit and to output a control signal based on the information about the change in length; and
a housing length adjuster configured to receive the control signal and to adjust the length of the variable housing based on the control signal.

13. The secondary battery module as claimed in claim 12, wherein the variable housing comprises:
a fixed housing configured to accommodate the battery cells; and
a movable housing partially accommodating the fixed housing and configured to be movable relative to the fixed housing.

14. The secondary battery module as claimed in claim 13, wherein one end portion of the fixed housing is closed and another end portion toward the movable housing is open, and
wherein the movable housing corresponds to the other end portion of the fixed housing.

15. The secondary battery module as claimed in claim 13, wherein two end portions of the fixed housing are open, and
wherein the movable housing corresponds to each of the two end portions of the fixed housing.
